# EUROPEAN PATENT APPLICATION

(11) **EP 2 209 178 A1**
(43) Date of publication of application: **21.07.2010**
(21) Application number: 09150673.3
(22) Date of filing: 15.01.2009
(51) Int. Cl.: H02J 7/00, H01M 10/44, G01R 31/36

(54) **Diagnostic charger for LEAD-ACID batteries**

(71) Applicant: TecMate (International), 3300 Tienen (BE)
(72) Inventor: Human, Martin, Oakville, Ontario L6H 2K9 (CA)
(74) Representative: pronovem

(57) **Abstract**

The present invention is related to a method for charging and testing a lead acid battery using a variable current and variable voltage supply, comprising the steps of:
- applying a bulk charging step wherein a current I_{c} is applied to the battery, while the resulting voltage Vₜᵢ is measured, said charging current I_{c} being regulated so that the variation of the voltage dVₜᵢ/dt, is maintained close to a predetermined target value, said bulk charging step being applied until Vₜᵢ reaches a predetermined first voltage, V_{tf};

applying a first retention test, wherein no current is delivered to the battery and battery voltage is measured after a first predetermined delay.

## Description

### Field of the Invention

The present invention is related to a method for charging and testing lead acid battery. It is also related to a device for running such method.

### State of the Art

Methods and apparatus for determining initial charging status, and for charging lead acid batteries are known in the art. A classical way to perform such an operation is to test initial battery status, then impose a constant current and stop the current when particular conditions are fulfilled.

A lot of documents describe how to decide whether the batteries are fully charged or not based upon voltage variation (dV/dt). For example, document WO 2003/030331 (annexed) describes such a method, this document further uses dV2/dt2 in order to determine the fully charged state. Such methods are particularly suitable for NiCd batteries, wherein the full charge status is characterised by a maximum voltage for a given charging current. In some cases, in a first stage, dV/dt is also evaluated in order to check the battery status, as described in document US544353 for NiCd batteries.

WO9616460 discloses a method for charging secondary batteries wherein a stepwise current is applied, current being decreased each time gassing voltage is reached. In a particular embodiment, dV/dt is also evaluated. This measurement is limited to an initial phase.

As problems occurring in lead acid batteries, sulphating of deep discharged batteries and non equilibrium of charging state of different electrolytic cells are of particularly importance.

### Aims of the Invention

The present invention aims to provide a method for charging and testing lead acid batteries that overcome the drawbacks of prior art methods.

More particularly, the present invention aims at improving testing procedure of a battery in a circuit.

### Summary of the Invention

The present invention is related to a method for charging and testing a lead acid battery using a variable current and variable voltage supply, comprising the steps of:
- applying a bulk charging step wherein a current (I_{c}) is applied to the battery, while the resulting voltage (Vₜᵢ) is measured, said charging current (I_{c}) being regulated so that the resulting variation in time of the voltage (dVₜᵢ/dt), is maintained close to a predetermined target value, preferably comprised between 20 and 200mV, more preferably between 70 and 130 mV/s, said bulk charging step being applied until (Vₜᵢ) reaches a predetermined first voltage, (V_{tf}) ;
- applying a first retention step, wherein no current is delivered to the battery and battery voltage is measured after a first predetermined delay, said first predetermined delay being advantageously about 30 minutes.

Preferably, said charging current is further limited to a predetermined current. Preferably, said predetermined current is about the nominal charging current of the battery.

By nominal charging current, it is meant the optimal charging current suitable for a medium discharged battery. This current is usually about 33% of the total capacity divided by one hour (i.e. a 10Ah would have 3,3A nominal charging current).

Preferably, the method of the present invention further comprises applying a second retention step after the first retention step if the battery voltage at the end of said first retention step is above a first predetermined value, said extended retention test being **characterised in that** no current is delivered to the battery, and the battery voltage is measured after a second predetermined delay, said second predetermined delay being advantageously much longer than the first predetermined delay, preferably more than ten times longer than the first predetermined delay, preferably about half a day.

Advantageously, at least both the first and second retention tests are performed with a device using the battery connected to said battery, said device being switched-off.

Preferably, the method of the present invention further comprises the steps of:
- applying an initial testing of the battery, determining an initial charging status;
- applying a recovery charging until a predetermined charging status is reached.

Preferably, the initial testing step comprises the following substeps sequence:
- measuring the initial voltage of the battery Vₜ₀ without charging current applied,
   - if the measured initial voltage Vₜ₀ is below a first predetermined value Vₜ₀ₘᵢₙ, which is advantageously comprised between 10 and 20% of the nominal voltage, preferably about 15% of the nominal voltage, the method stops;
   - if measured initial voltage Vₜ₀ is above a second predetermined value which is preferably comprised between 108% and 115% of the nominal voltage, the battery status is considered as not deep discharged and the initial testing step terminates;
- applying a current Iₜₑₛₜ and waiting for about a period of less than e few second, preferably less than half a second, said current Iₜₑₛₜ being comprised between 5 and 15% of the nominal charging current of the battery;
- measuring the resulting voltage Vₜ₁, if the measured voltage Vₜ₁ is above a predetermined value Vₜ₀ₘₐₓ comprised between 115% and 120% of the nominal voltage, the battery status is considered as deep-discharged.

Advantageously, the recovery charging step comprises the following substeps of:
- applying a recovery charging current I_{cr} to the battery, said recovery charging current I_{cr} being comprised between 5% and 15% of the nominal charging current of the battery;
- measuring the resulting voltage;
- if the voltage of the battery rises above a predetermined value Vₘₐₓ comprised between 130% and 190% of the nominal voltage of said battery, limit the applied voltage to said predetermined value Vₘₐₓ,
said recovery charging step being applied until the voltage of the battery drops below a predetermined value V_{trec} comprised between 113% and 117% of the nominal voltage, or the total duration of the recovery charging step has exceeded a predetermined recovery delay, said recovery delay being advantageously more than 1 hour, preferably, about 2 hours.

Optionally, the recovery charging step is applied only if the determined initial battery status is deep discharge.

Preferably, the recovery charging step is followed by an additional step applying current pulses, varying the resulting voltage between about 113% and about 120% of the nominal voltage of the battery.

Advantageously, the bulk charging step is followed by current pulses, varying the resulting voltage between about 113% and about 120% of the nominal voltage.

Preferably, the method of the present invention also includes additional maintenance step wherein a predetermined voltage of about 113% of the nominal voltage of the battery is applied to said battery in active periods representing half of the total time, no current being applied the rest of the time. Active periods having duration of about 30 minutes are preferred.

The present invention also relates to lead-acid charger comprising means for implementing the method of the present invention.

### Brief Description of the Drawings

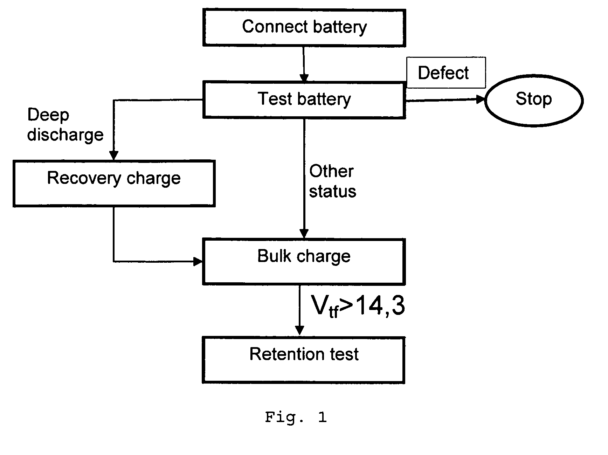

Fig. 1 is representing a flow diagram of a particular realisation of the present invention.

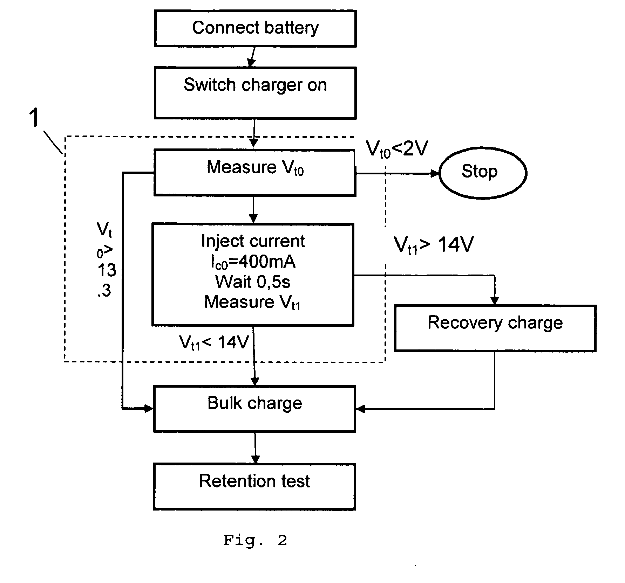

Fig. 2 is representing a flow diagram of a particular realisation of the present invention, including a particular initial testing method.

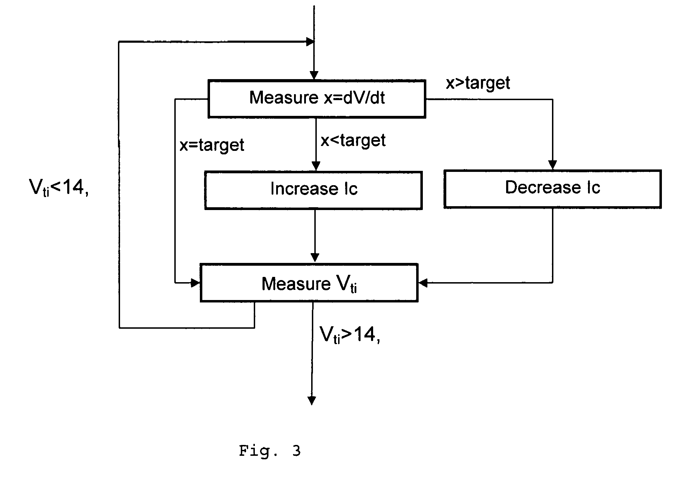

Fig. 3 is representing a flow diagram of a regulation loop of the bulk charging step according to the present invention.

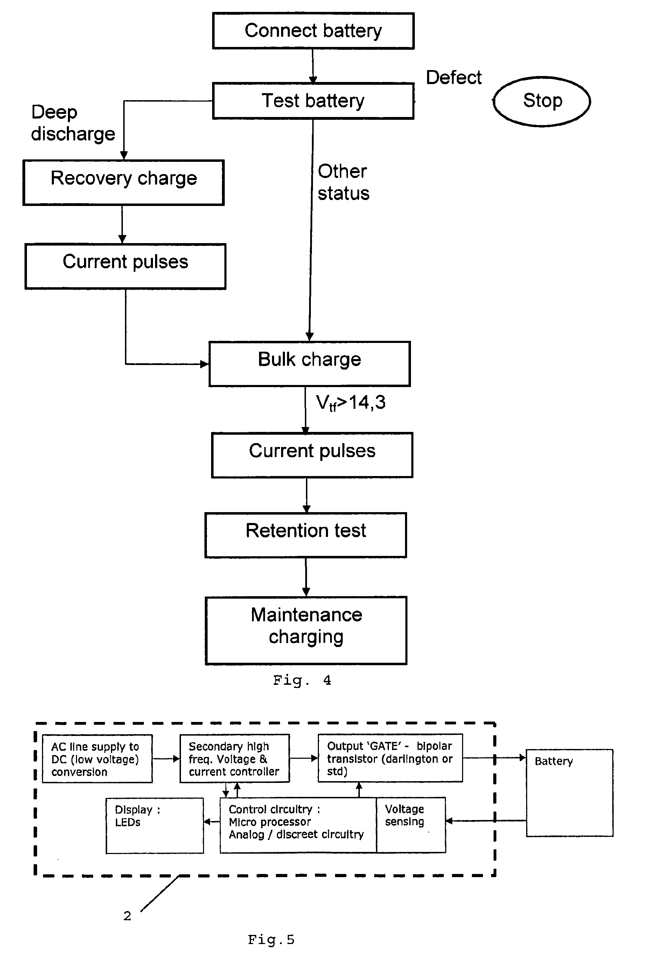

Fig. 4 is representing a flow diagram of a particular embodiment of the present invention.

Fig. 5 is representing the general setup of the electronic circuit of the present invention.

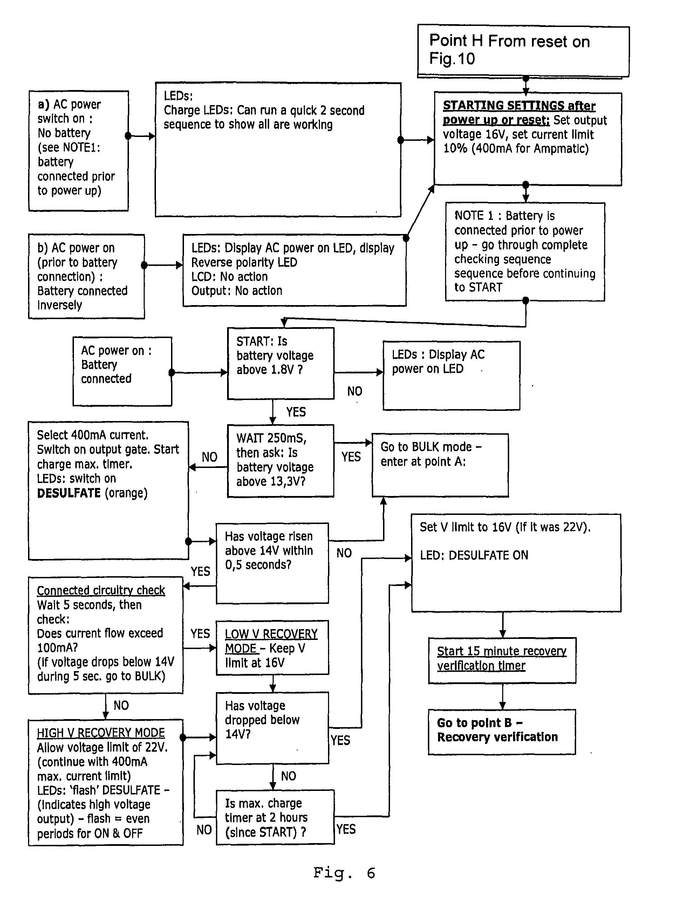

Fig. 6 is representing the first part of a block diagram of a preferred embodiment of the method of the present invention, including testing steps and initial charging.

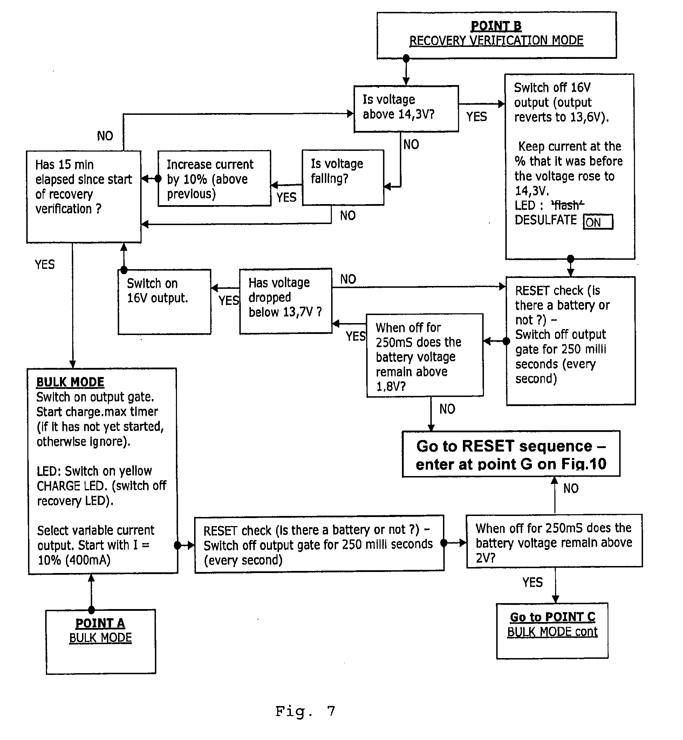

Fig. 7 is representing the second part of the block diagram of a preferred embodiment of the method of the present invention.

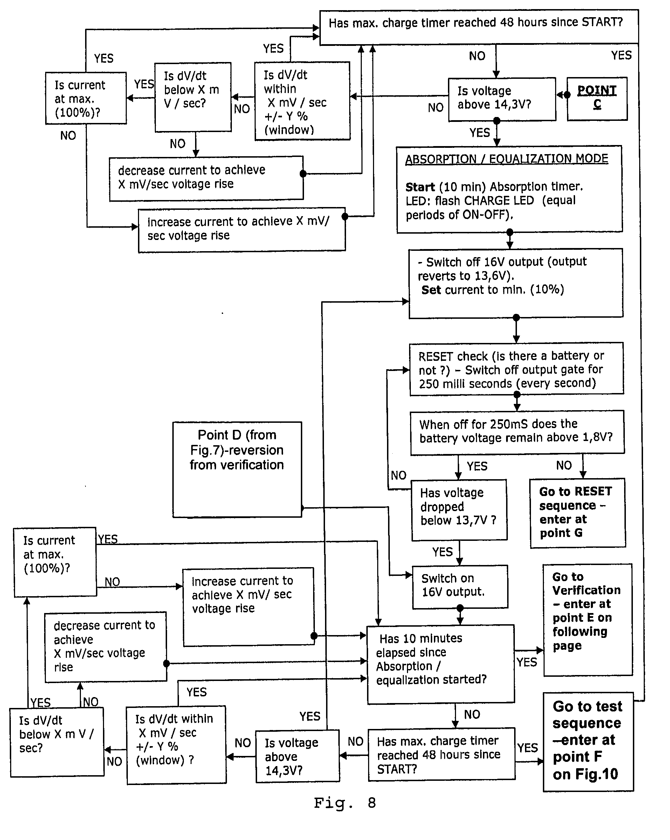

Fig. 8 is representing the third part of the block diagram of a preferred embodiment of the method of the present invention.

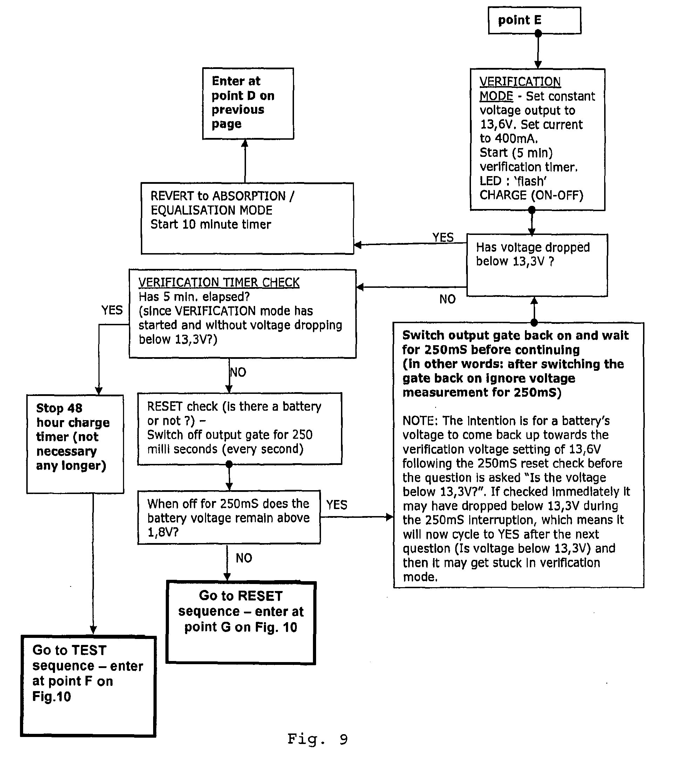

Fig. 9 is representing the fourth part of the block diagram of a preferred embodiment of the method of the present invention.

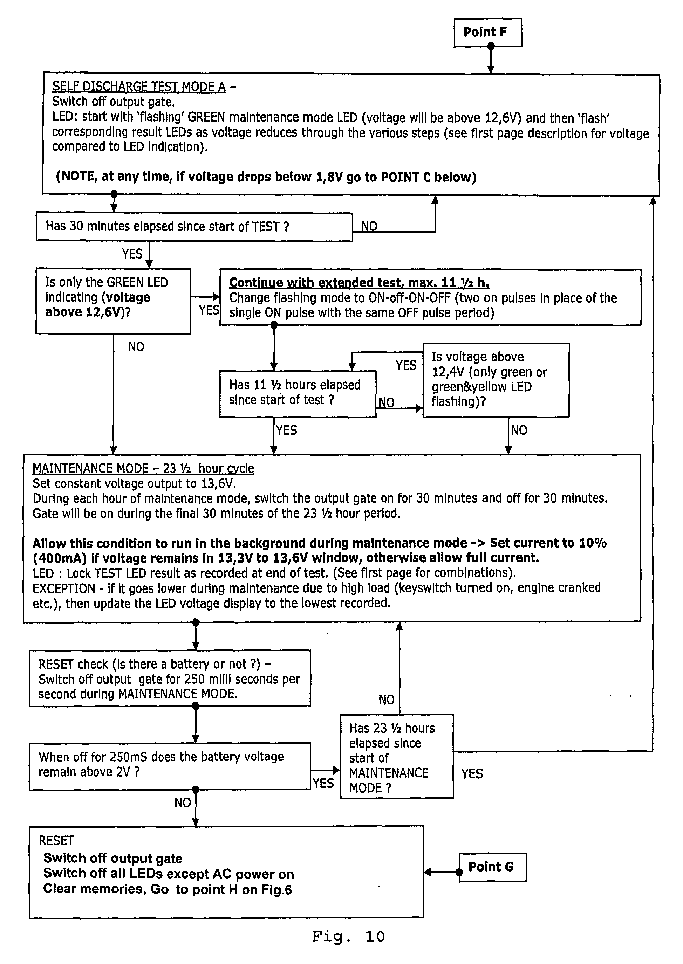

Fig. 10 is representing the fifth part of the block diagram of a preferred embodiment of the method of the present invention.

### Detailed Description of the Invention

In its simplest embodiment, the method of the present invention comprises an initial testing step, wherein the initial charging status is defined, if needed, a recovery charging step, a bulk charging step, wherein the current is regulated to maintain a particular voltage variation, and a retention test step at the end, in order to verify that the battery is capable of retaining sufficient charge.

The current regulation based upon the voltage variation is particularly efficient in optimising the charging efficiency of the charger of the present invention. Particularly, contrary to most prior art wherein the current is stepped down throughout the charging process, the current in the method of the present invention can both increase or decrease in response to dV/dt variation. Furthermore, this regulation is performed on an almost continuous basis, avoiding fast current variation and maintaining the current as close as possible to its optimal value.

In the retention test performed at the end of the bulk charging step, no current is applied to the battery, and the voltage is measured after a predetermined time. 30 minutes is a good compromise between too long time to get results and sensitivity of the test.

Advantageously the result of the retention test can be confirmed by an extended retention test, having a duration of several hours. Twelve hours for short and extended test together is a preferred value.

It can be useful to maintain the battery in the circuit of the device using it during the retention test(s), as in that case, abnormal current drainage can be detected. If there are strong differences between the results of the retention test with battery connected to the circuit and without battery connected to the circuit, there is strong probability that there is an insulation defect in the circuit of the device.

The method of the present invention can also include additional steps. In order to equilibrate the charging status of the different cells composing the battery, it has been found that varying the applied voltage between two values and applying corresponding current pulses was particularly efficient. Varying voltage between 13,7 and 14,3 V for 12 V standard batteries was well adapted, corresponding respectively to 113 and 120% of the nominal voltage of the battery.

This last procedure of applying alternatively 14,3 and 13,7 V to the battery was also found useful after the recovery charging step, improving the ability of the battery to accept current before the bulk charging step.

Preferably, in the initial recovery step both the current and voltage are limited. The current in that stage is preferably limited to less than about 10% the nominal charging current of the battery, and the voltage is limited to less than 185% (i.e. 22V for a 12V battery) of the nominal voltage, preferably less that 133% (i.e. 16V for a 12V battery). For usual lead acid battery, such as those used in motorcycles and car, 400 mA is a suitable common value for the current limitation in this recovery step.

In order to avoid long term degradation of the battery after the charging procedure, a maintenance procedure can be applied by the same charger. In this procedure, rest periods alternate with charging periods wherein a suitable voltage is applied to the battery. As suitable voltage, 13,6 V was found optimal for 12 V battery (i.e. 113% of the nominal voltage). Preferably, the duration of said periods is around half an hour, too short periods inducing non equilibrium status, and too long periods inducing too strong variation of the charge battery status.

Preferably, the end of the recovery charging step determined by a battery voltage measurement, said step being terminated either when the voltage drops below a particular value, or after a predetermined delay. The particular

### Description of a Preferred Embodiment of the Invention

In this particular embodiment, all preferred features are included in one particular preferred charger, piloted by an electronic circuit. Said charger is used specifically for charging a 12 V lead acid battery. It can easily be scaled to any other nominal voltage.

In a very first step, the charger output will only activate if a battery retaining at least 2V is connected, whereupon the micro processor diagnoses the battery condition and engages the appropriate charge mode corresponding charge status. This initial diagnostic is performed by testing the voltage of the battery with open circuit. The battery status is not considered as being deep discharge if the initial voltage is above 13,3V. If the voltage is lower than 13,3V, further testing is performed, injecting a 400 mA current in the battery for 0,5 second, if the voltage then rise above 14V, the battery is considered deep discharged.

If the battery is extremely flat (deep-discharged and sulphated), the recovery mode will engage. A special high voltage is then applied to force a very small fixed current into the battery in a recovery attempt that may last for a maximum of two hours. Initially the voltage is limited to about 16V for 5 seconds while the circuit assesses whether this level is sufficient to recover the battery, this is the case if the current resulting from the applied voltage rises above 100mA. If the assessment is positive the voltage remains limited at 16V.

If the assessment is negative, typically for a badly neglected battery that has not received any charge for many months, the second more powerful stage will engage with the voltage limit reset to 22V.

In any cases, in the recovery mode, the current is limited to 400mA. Once the battery accepts the very low set current (400mA) the voltage will reduce until the moment when the automatic circuit determines that the battery can accept the final stage of the recovery programme. This is the case when the resulting battery voltage has dropped below 14V.

During 15 minutes the charger current control will now deliver current in pulses whilst maintaining the voltage below 14,3V, to further prepare the battery to accept normal charge. This mode is particularly effective for initiating recovery of factory activated / "high performance" pure lead or cyclic cell AGM batteries.
If the battery remains connected to a vehicle electrical system (even with ignition key in off position) the second recovery stage cannot engage.

A bulk charge stage will engage if the micro processor determines that the battery can accept normal charge current. The charger charge current monitoring and control mode automatically determines the most efficient rate of charge current for the connected battery, according to its state of charge, state of health, and electrical storage capacity. The delivered current may be anywhere from 0,4A to 5A.

In the bulk charge stage, the current is based upon a voltage variation (dV/dt) measurements. More precisely, the applied current is adjusted to maintain dV/dt close to a target value. By "close", we mean that variations of about +/- 30% around the target value are not taken into account. This is performed through an iterative procedure, in which the voltage variation is first measured, if dV/dt is too high, the current is decreased, if dV/dt is too low, the current is increased, except if the current is already at the maximum charging capacity of the charger (physical limit of the charging circuit). The target voltage variation is advantageously comprised between 20 and 200mV/s, preferably between 70 and 130 mV/s.

For example, if a first voltage measurement is V1, and one second later, a second voltage measurement is V2, let us define V3 as V3= V2 - V1. Then, the regulation procedure becomes:
- If V3 is less than about 70mV, charging current will increase 5%.
- If V3 is between about 70mV and about 100mV, charging current will increase 1%.
- If V3 is equal to about 100mV, charging current is not adjusted.
- If V3 is between about 100mV and about 130mV, charging current will decrease 1%.
- If V3 is greater than about 130mV, charging current will decrease 2%.

A pulsed absorption stage starts when the voltage has reached 14,3V for the first time during bulk charge stage. During 10 minutes the charger current control delivers pulses of current so as to vary the battery voltage between 13,7V and 14,3V. This procedure has been found particularly efficient to equalise the individual cells within the battery and bring it to full charge as rapidly as possible.

A charge verification procedure follows the pulsed absorption. In this procedure, the charging voltage is limited at 13,6V during 5 minutes whilst the battery's charge level is verified. If the battery requires further charging the programme will revert to the pulsed absorption stage. These reversions may occur as many times as is necessary to reduce the battery's current demand below 400mA at 13,6V (which is consistent with a battery that has accepted as much charge as its basic condition allows). As soon as the circuit has verified that the charge is adequate a voltage retention test automatically follows.

During the voltage retention test, delivery of current to the battery is interrupted to allow the circuit to monitor the battery's voltage decline to determine its ability to retain charge and deliver power. If voltage drops below 12,7V, a maintenance mode is engaged, and a status message will be provided by the charger to the user indicating that the battery has low retention capacity. This can mean that the battery is defective, or that the circuit of the device the battery is connected to has current loss, due either to insulation defects, or in-circuit current consuming accessories.

If, after 30 minutes the voltage is still above 12,7V, an extended voltage retention test is performed. The extended voltage retention test checks for excessive self discharge, whether caused by the battery itself, (as even a partly damaged battery may initially retain sufficient power, but lose power faster than normal thereafter) or by higher than expected power loss through the device electrical system. If the voltage drops below 12,4V, the battery or circuit will be considered as having low retention capacity, and the charger gets into a maintenance mode. If after 11h30 the voltage remains above 12,4V, the battery will be considered as being in good state, and the maintenance mode is engaged.

The maintenance mode consists of 30 minute float charge periods followed by and alternating with 30 minute rest periods during which there is no charge current. This 50% duty cycle prevents loss of electrolyte in sealed batteries and minimizes gradual loss of water from the electrolyte in batteries with filler caps, and thereby contributes significantly to optimizing the service life of irregularly or seasonally used batteries. The circuit offers current to the battery within a safe 13,6V voltage limit ("float charge"), allowing it to draw whatever small current is necessary to sustain it at (or close to) full charge and compensate for any small electrical loads imposed by vehicle accessories or on-board computer, or the natural gradual self-discharge of the battery itself.

The voltage retention test cycle, followed by the maintenance charge cycle, will repeat 24 hours after the start of the very first test and continue to repeat as long as the charger remains connected to the battery.

## Claims

1. A method for charging and testing a lead acid battery using a variable current and variable voltage supply, comprising the steps of:
- applying a bulk charging step wherein a current (I_{c}) is applied to the battery, while the resulting voltage (Vₜᵢ) is measured, said charging current (I_{c}) being regulated so that the resulting variation in time of the voltage (dVₜᵢ/dt), is maintained close to a predetermined target value, said bulk charging step being applied until (Vₜᵢ) reaches a predetermined first voltage, (V_{tf}) ;
- applying a first retention step, wherein no current is delivered to the battery and battery voltage is measured after a first predetermined delay.

2. The method of claim 1 wherein the predetermined target value is comprised between 20 and 200mV/s.

3. The method of claim 2 wherein the predetermined target value is comprised between 70 and 130 mV/s.

4. The method of claim 1 wherein the current (I_{c}) is further limited to a predetermined current value.

5. The method of any of previous claims further comprising an second retention step after the first retention step if the battery voltage at the end of said first retention step is above a first predetermined value, said extended retention test being **characterised in that** no current is delivered to the battery, and the battery voltage is measured after a second predetermined delay of at least ten times longer than the first predetermined delay.

6. The method of claim 5 wherein at least both the first and second retention tests are performed with a device using the battery connected to said battery, said device being switched-off.

7. The method according to any of previous claims further comprising the steps of:
- applying an initial testing (1) of the battery, determining an initial charging status;
- applying a recovery charging until a predetermined charging status is reached.

8. The method according to claim 7 wherein the initial testing step comprises the following substeps sequence:
- measuring the voltage of the battery Vₜ₀ without charging current applied,
• if the measured voltage Vₜ₀ is below about 15% of the nominal voltage, the method stops;
• if measured voltage Vₜ₀ is above a second predetermined value of about 110% the nominal voltage, the battery status is considered as not deep discharged and the initial testing step terminates;
- applying a current Iₜₑₛₜ of about 10% the nominal charging current of the battery and waiting for about half a second;
- measuring the resulting voltage Vₜ₁, if the measured voltage Vₜ₁ is above about 117% of the nominal voltage, the battery status is considered as deep-discharged.

9. The method according to claims 7 or 8 wherein the recovery charging step comprises the following substeps of:
- applying a recovery charging current I_{cr} to the battery, said recovery charging current I_{cr} being about 10% the nominal charging current of the battery;
- measuring the resulting voltage;
- if the voltage of the battery rises above a predetermined value Vₘₐₓ comprised between 130% and 190% of the nominal voltage of said battery, limit the applied voltage to said predetermined value Vₘₐₓ,
said recovery charging step being applied until the voltage of the battery drops below about 115% of the nominal voltage, or the total duration of the recovery charging step has exceeded two hours.

10. The method according to claim 9 wherein the recovery charging step is followed by an additional step applying current pulses, varying the resulting voltage between 113% and 120% of the nominal voltage of the battery.

11. The method according to any of previous claims wherein the bulk charging step is followed by current pulses, varying the resulting voltage between 113% and 120% of the nominal voltage.

12. The method according to any of previous claims comprising an additional maintenance step wherein a predetermined voltage of about 113% of the nominal voltage of the battery is applied to said battery in active periods representing half of the total time, no current being applied the rest of the time.

13. The method of claim 10 wherein the active periods have duration of about 30 minutes.
